**Europäisches Patentamt**

**European Patent Office**

**Office européen des brevets**

(19)

(11) Veröffentlichungsnummer: **0 264 575**
**A2**

(12) **EUROPÄISCHE PATENTANMELDUNG**

(21) Anmeldenummer: 87112214.9

(22) Anmeldetag: 22.08.87

(51) Int. Cl.⁴: **H04N 5/782**

(30) Priorität: 26.08.86 DE 3628964

(43) Veröffentlichungstag der Anmeldung:
27.04.88 Patentblatt 88/17

(84) Benannte Vertragsstaaten:
AT BE CH DE ES FR GB IT LI NL SE

(71) Anmelder: **Standard Elektrik Lorenz Aktiengesellschaft**
**Lorenzstrasse 10**
**D-7000 Stuttgart 40(DE)**

(72) Erfinder: **Schröder, Wolfgang**
**Allensteiner Strasse 13**
**D-7530 Pforzheim(DE)**

(74) Vertreter: **Pohl, Heribert, Dipl.-Ing et al**
**Standard Elektrik Lorenz AG Patent- und**
**Lizenzwesen Postfach 30 09 29**
**D-7000 Stuttgart 30(DE)**

(54) **Verfahren zum Auslösen einer Schaltfunktion in einem programmierbaren Empfangsgerät der Unterhaltungselektronik.**

(57) Durch das VPS-System wird es möglich, den Betrieb eines Empfangsgerätes der Unterhaltungselektronik, z.B. eines Videorecorders, in dem zu einem späteren Zeitpunkt zu empfangende Sendungen einprogrammiert sind, so zu steuern, daß auch Sendungen einwandfrei empfangen und aufgezeichnet werden, die zu einem früheren oder späteren Zeitpunkt als vorgesehen ausgesendet werden. Mit dem VPV-System wird die Programmierung gewünschter Sendungen für den Benutzer einfacher und fehlerfreier, da er die Programmwunsch-Daten direkt aus einer Videotexttafel in das Empfangsgerät übertragen kann. Sind mehrere Programmwünsche in das Gerät einprogrammiert, so können die einzelnen Sendungen nur dann einwandfrei aufgezeichnet werden, wenn die zugehörigen Sender laufend zyklisch abgetastet werden.

Die üblicherweise in ihrer zeitlichen Reihenfolge einprogrammierten Programmwunsch-Daten werden, um unerwünschte Frequenzhub-Störungen zu vermeiden, vor Beginn des Sender-Suchvorgangs nach auf-oder absteigenden Frequenzen geordnet.

```
  ┌─relative Frq.
  │   ┌─Pr.Quelle
  ▼   ▼    Sp.Platz
11    A   2
12
13    8   1
14    C   4
15
16    D   3
17
18
19    E   5
20
21    F   6
22    G   7
22    H   8
23
24    I   9
25
26    J  10
27    K  11
28
29    L  12
30    M  13

Fig. 1
```

| Dat. | Zeit | VPS-Zt. | Pr. | Sp. | Frq. |
|------|------|---------|-----|-----|------|
| 3.5. | 1710 | (1710) | D | 3 | 16 |
| 3.5. | 1900 | (1900) | C | 4 | 13 |
| 3.5. | 2015 | (2014) | A | 2 | 11 |
| 3.5. | 2245 | (2246) | F | 6 | 21 |
| 4.5. | 1500 | (1500) | E | 5 | 19 |
| 4.5. | 1900 | (1900) | B | 1 | 12 |

Fig. 2

| Frq. | Pr. | Sp. |
|------|-----|-----|
| 11 | A | 2 |
| 12 | B | 1 |
| 13 | C | 4 |
| 16 | D | 3 |
| 19 | E | 5 |
| 21 | F | 6 |

Fig. 3

# Verfahren zum Auslösen einer Schaltfunktion in einem programmierbaren Empfangsgerät der Unterhaltungselektronik

Die Erfindung betrifft ein Verfahren nach dem Oberbegriff des Patentanspruchs. Ein solches Verfahren ist z.B. aus der DE-OS 33 07 885 (internes Aktenzeichen S.Apitz 20) bekannt. Die unter den Bezeichnungen VPS und VPV bekannten Systeme sind dazu bestimmt, den Benutzern von komfortablen Empfangsgeräten der Unterhaltungselektronik, insbesondere von Videorecordern, die Programmierung des Gerätes zu erleichtern (vgl. z.B. Funkschau 11/1986, Seiten 40 bis 43). Unter Programmierung wird hier das Eingeben einer oder mehrerer Sendungen verstanden, die zu einem späteren Zeitpunkt ausgestrahlt werden und zu deren Empfang oder Aufzeichnung das Gerät sich selbständig einschalten soll. Bei VPS wird das Gerät durch eine von dem Sender ausgestrahlte individuelle Sendungskennung zeitrichtig eingeschaltet. Es werden auch solche Sendungen einwandfrei empfangen und aufgezeichnet, die zu einem früheren oder späteren Zeitpunkt als ursprünglich vorgesehen ausgesendet werden. VPV erleichtert die Programmierung des Empfangsgerätes und vermeidet Fehlbedienungen dadurch, daß die Daten einer gewünschten Sendung nicht manuell in das Gerät eingegeben werden müssen, sondern direkt von einer Videotext-Programmtafel in den sog. Programmwunschspeicher übernommen werden.

Das durch eine Sendungskennung gesteuerte selbsttätige Aufnehmen von Programmbeiträgen ist auch für Hörfunksendungen sinnvoll, im folgenden wird aber der Einfachheit halber nur von Videorecordern gesprochen.

Der wie besprochen programmierte Videorecorder wird bei Beginn eines Bereitschaftszeitraums, für den auch die Bezeichnung Zeitfenster üblich ist, mit seinem Empfangsteil eingeschaltet, während der Aufnahme-oder Wiedergabeteil noch ausgeschaltet bleiben. Der Bereitschaftszeitraum beginnt um eine vorgegebene Zeitspanne oder zu einem vorgegebenen Zeitpunkt vor der Anfangszeit der gewünschten Sendung (Vorlaufzeit) und endet um eine vorgegebene Zeitspanne oder zu einem vorgegebenen Zeitpunkt nach dieser Anfangszeit (Nachlaufzeit). So kann das Empfangsteil z.B. um 0 Uhr an dem Tag der gewünschten Sendung eingeschaltet und spätestens um 4 Uhr am nächsten Tag ausgeschaltet werden.

Ab Beginn des Bereitschaftszeitraums wird der Tuner schrittweise nacheinander auf die im Programmwunschspeicher gespeicherten Sender abgestimmt. Dieser Sender-Suchvorgang - auch als Scannen bekannt-wird laufend zyklisch wiederholt, und zwar so lange, bis eine Übereinstimmung zwischen einer von einem der überwachten Sender empfangenen Sendungskennung und einer der eingegebenen Sendungskennungen festgestellt wird. Es wird dann die vorgesehene Schaltfunktion ausgelöst, z.B. der Aufnahmeteil des Videorecorders eingeschaltet, und der Sender-Suchvorgang beendet.

Der Benutzer wird die gewünschten Sendungen in den Programmwunschspeicher oder die Programmiertabelle normalerweise in zeitlicher Reihenfolge eingeben. Dabei sind aber die Trägerfrequenzen der abzusuchenden Sender völlig umgeordnet. Dies verlangsamt den Sender-Suchvorgang und kann außerdem zu Störungen aufgrund des großen Frequenzhubes führen.

Der Erfindung liegt die Aufgabe zugrunde, den Sender-Suchvorgang in möglichst kurzer Zeit ablaufen zu lassen und die Gefahr von Frequenzhubstörungen zu vermeiden.

Diese Aufgabe wird bei dem eingangs genannten Verfahren erfindungsgemäß dadurch gelöst, daß die Programmquellen-Daten vor Beginn des Sender-Suchvorgangs nach auf-oder absteigenden Frequenzen geordnet werden.

Ein Ausführungsbeispiel der Erfindung wird im folgenden anhand der in der Zeichnung dargestellten Tabellen erläutert. Es zeigen:

Fig. 1 eine Sendertabelle,

Fig. 2 eine nach der Startzeit geordnete Programmiertabelle eines Empfangsgeräts der Unterhaltungselektronik, und

Fig. 3 eine aus der Fig. 2 abgeleitete und umsortierte reduzierte Suchtabelle.

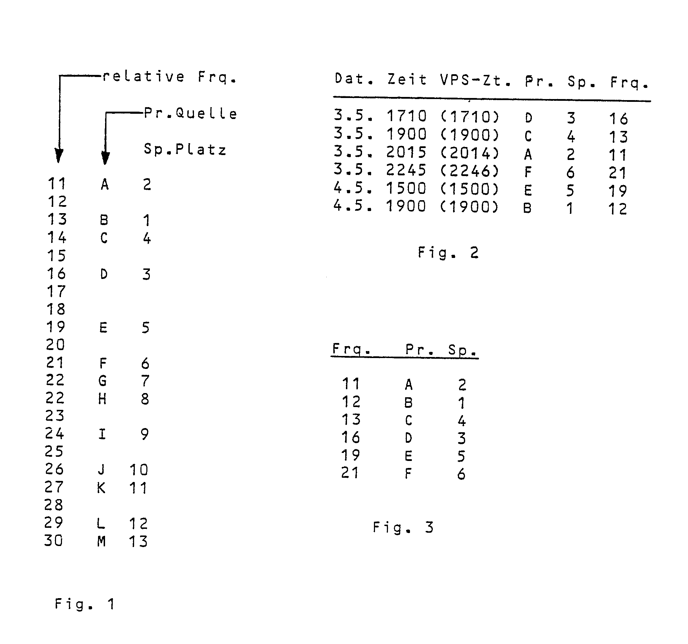

Die aus Fig. 1 ersichtliche Sendertabelle enthält eine "relative" Frequenzscala 11...30, d.h. die Senderfreuqenzen sind nicht durch ihren wirklichen Frequenzwert dargestellt sondern durch eine Zahl symbolisiert. An dem Empfangsort sind den zu empfangenden Sendern A bis M Speicherplätze 1 bis 30 des Videorecorders zugeordnet. Es sei hier erwähnt, daß es Orte gibt, an denen bereits bis zu 30 verschiedene Fernsehkanäle über Breitbandkabel empfangen werden können. Bei bekannten Videorecordern werden in dem Bereitschaftszustand ("Lauerstellung") alle diese Kanäle zyklisch abgefragt. Dabei beginnt der Sender-Suchvorgang je nach Gerät Minuten oder Stunden vor dem vorgesehenen Anfangszeitpunkt der einprogrammierten gewünschten Sendung. Bei einem solchen Suchvorgang kann sich eine Verzögerung von bis zu 15 Sekunden ergeben, ehe der Videorecorder auf Empfangsbetrieb geschaltet werden kann. Dazu kommt noch die mechanische Anlaufzeit des Geräts.

Die aus Fig. 2 ersichtliche Programmiertabelle eines Videorecorders enthält die nach der Anfangszeit der gewünschten Sendungen geordneten Sendungs-und Programmquellen-Daten. Die Anzahl der Programmierzeilen, die jeweils abgespeichert werden können, hängt von dem Videorecordertyp ab. Da aber die Aufnahmekapazität von Videokassetten zeitlich begrenzt ist, erscheint es nicht sinnvoll, wesentlich mehr Programmierzeilen als dargestellt vorzusehen.

Aus der Fig. 3 ist eine Suchtabelle ersichtlich, die aus der Programmiertabelle nach Fig. 2 abgeleitet, nach z.B steigenden Frequenzen geordnet und gegenüber der normalen Sender-Suchlauftabelle reduziert ist. Der nach dieser Tabelle durchgeführte zyklische Sender-Suchvorgang bewirkt beim Erkennen der von einem Sender empfangenen VPS-Sollzeit, die als Befehl zum Starten der Aufzeichnung dient, eine wesentlich geringere Totzeit als bei Verwendung der Tabelle nach Fig. 1.

Die Totzeit läßt sich in mehreren Stufen verringern, wobei jede Stufe einen etwas höheren Steueraufwand erfordert, sich aber ohne weiteres mit Hilfe von Mikrorechnern realisieren läßt.

Stufe 1:

Es wird nur die Tabelle der Fig. 2 benutzt, wobei die Speicherplatz-Daten 3,4,2,6,5,1 oder die relativen Fernsehkanalfrequenz-Daten 16,13,11,21,19,12 in zyklischer Reihenfolge eingesetzt werden, um den Abstimmvorgang des Fernsehtuners zu steuern. Dabei werden statistisch verteilte Frequenzsprünge und dadurch möglicherweise bedingte längere Abstimmzeiten und höhere Frequenzstörhub-Sprünge in Kauf genommen.

Stufe 2:

Die reduzierte Tabelle nach Fig. 3 wird in zyklischer Reihenfolge benutzt, und zwar entweder anhand der Speicherplatz-Datenfolge 2,1,4,3,5,6 oder anhand der damit übereinstimmenden Kanalfrequenz-Datenfolge 11,13,14,16,19,21. Hier sind die Frequenzsprünge in monotoner Folge auf das mögliche Minimum reduziert, und ebenso die Abstimmzeiten.

Stufe 3:

Es wird zusätzlich die Reihenfolge der Bereitschaftszeiträume berücksichtigt, indem nur Programmquellen-Daten aus der Tabelle nach Fig. 2 oder nach Fig. 3 herangezogen werden, für die die jeweilige Bereitschaftzeit bereits begonnen hat. So werden am 3.5. nur die Progrmmquellen-Daten D,C,A,F nach Stufe 1 sortiert oder A,C,D,F nach Stufe 2 sortiert und zum Steuern des Sender-Suchlaufvorgangs benutzt. Am 4.5. dagegen werden die Programmquellen-Daten F,E,B oder B,E,F benutzt. Die Verringerung der Totzeit für den Beginn des Aufnahmebetriebes nach der Stufe 3 gegenüber den Stufen 1 und 2 erfolgt nach statistischen Gesetzmäßigkeiten.

## Ansprüche

Verfahren zum Auslösen einer Schaltfunktion in einem programmierbaren Empfangsgerät der Unterhaltungselektronik mittels einer von einem Sender zusammen mit der jeweiligen Sendung ausgestrahlten Sendungskennung,

-bei dem die Sendungskennung sowie das Datum und die Programmquellen-Daten der gewünschten Sendungen in einen Programmspeicher des Empfangsgerätes eingeschrieben werden,

-bei dem aus der Sendungskennung die vorgesehene Startzeit der Sendung ermittelt und zu Beginn einer vorgegebenen Bereitschaftszeit vor der Startzeit ein sich zyklisch wiederholender Sender-Suchvorgang begonnen wird,

-bei dem, sobald eine Übereinstimmung zwischen einer von einem Sender empfangenen Sendungskennung und einer eingegebenen Sendungskennung festgestellt wird, die Schaltfunktion ausgelöst und der Sender-Suchvorgang beendet wird, und

-bei dem zum Steuern Sender-Suchvorgangs die in dem Programmspeicher abgelegten Programmquellen-Daten verwendet werden,

**dadurch gekennzeichnet,**

daß die Programmquellen-Daten vor Beginn des Sender-Suchvorgangs nach auf-oder absteigenden Frequenzen geordnet werden.

```
                                    Dat.  Zeit VPS-Zt.  Pr.  Sp.  Frq.
┌── relative Frq.
│                                   3.5.  1710  (1710)   D    3    16
│   ┌──── Pr.Quelle                 3.5.  1900  (1900)   C    4    13
│   │                               3.5.  2015  (2014)   A    2    11
│   │     Sp.Platz                  3.5.  2245  (2246)   F    6    21
↓   ↓                               4.5.  1500  (1500)   E    5    19
11   A     2                        4.5.  1900  (1900)   B    1    12
12
13   B     1                                Fig.  2
14   C     4
15
16   D     3
17
18
19   E     5
20                                  Frq.      Pr.  Sp.
21   F     6
22   G     7                         11        A    2
22   H     8                         12        B    1
23                                   13        C    4
24   I     9                         16        D    3
25                                   19        E    5
26   J    10                         21        F    6
27   K    11
28
29   L    12                                Fig.  3
30   M    13
```

Fig. 1